Europäisches Patentamt

European Patent Office

Office européen des brevets

(11) Veröffentlichungsnummer: **0 296 379**

**A2**

(12) **EUROPÄISCHE PATENTANMELDUNG**

(21) Anmeldenummer: 88108589.8

(22) Anmeldetag: 30.05.88

(51) Int. Cl.⁴: **H01L 39/24 , H01B 12/02 , H01B 12/10 , C04B 35/00**

(30) Priorität: 26.06.87 DE 3721147

(43) Veröffentlichungstag der Anmeldung: 28.12.88 Patentblatt 88/52

(84) Benannte Vertragsstaaten: CH DE FR GB IT LI NL

(71) Anmelder: VACUUMSCHMELZE GMBH
Grüner Weg 37 Postfach 2253
D-6450 Hanau 1(DE)

(72) Erfinder: Hillmann, Hans, Dr.
Innerer Ring 2
D-6454 Bruchköbel(DE)
Erfinder: Szulczyk, Andreas
Im Hirtengarten 31
D-6464 Linsengericht 5(DE)

(54) Verfahren zur Herstellung von draht- und/oder bandförmigen Supraleitern aus keramischer Sintermasse.

(57) Verfahren zur Herstellung von draht- und/oder bandförmigen Supraleitern aus keramischer Sintermasse, wobei das homogene supraleitende Material feinkörnig zermahlen und in geeignete Hüllkörper (z. B. Rohre oder Taschen) aus hoch kaltverformbaren Metallen gefüllt wird und anschließend die gefüllten Hüllkörper durch Kaltverformung auf den gewünschten Querschnitt gebracht werden.

EP 0 296 379 A2

## Ansprüche

1. Verfahren zur Herstellung von draht- und oder bandförmigen Supraleitern aus keramischer Sintermasse, wobei aus mehreren verschiedenen oxidischen Pulvern durch Mischen, Pressen, Sintern und Mahlen sowie thermische Behandlung ein homogenes supraleitendes Material hergestellt wird, **dadurch gekennzeichnet,** daß das homogene supraleitende Material feinkörnig zermahlen wird, daß das feinkörnige Material in geeignete Hüllkörper (z. B. Rohre oder Taschen) aus hoch kaltverformbaren Metallen gefüllt wird und daß die gefüllten Hüllkörper durch Kaltverformung auf den gewünschten Querschnitt gebracht werden.

2. Verfahren nach Patentanspruch 1, **dadurch gekennzeichnet,** daß das Zermahlen, Pressen, Sintern und Wärmebehandeln des keramischen Materials vor dem Einfüllen in die Hüllkörper so oft wiederholt wird, bis die gewünschte Homogenität und Supraleitfähigkeit erreicht ist.

3. Verfahren nach den Ansprüchen 1 oder 2, **dadurch gekennzeichnet,** daß mehrere gefüllte und auf einen vorgegebenen Querschnitt reduzierte Hüllkörper (Rohre oder Taschen) zur Herstellung eines Mehrfachverbundes für filamentierte Leiter (Mehrkernleiter) als Bündel in einen weiteren Hüllkörper, insbesondere aus Stabilisierungsmetall, eingesetzt und erneut durch ein Kaltverformungsverfahren auf Enddimension gebracht werden.

4. Verfahren nach einem der Ansprüche 1 bis 3, **dadurch gekennzeichnet,** daß zur Erzeugung einer zusammenhängenden Sintermasse in den kaltverformten Hüllkörpern und zur Einstellung der optimalen supraleitenden Eigenschaften der Sintermasse nach der endgültigen Formgebung eine Schlußwärmebehandlung erfolgt.

5. Verfahren nach einem der Ansprüche 1 bis 4, **dadurch gekennzeichnet,** daß als hoch kaltverformbare Metalle für die Hüllkörper Tantal, Niob, Vanadium oder dgl. verwendet werden.

6. Verfahren nach einem oder mehreren der Ansprüche 1 bis 5, **dadurch gekennzeichnet,** daß die aus kaltverformbaren Metallen bestehenden Hüllkörper mit Kupfer stabilisiert sind.

7. Verfahren nach einem der Ansprüche 1 bis 6, **dadurch gekennzeichnet,** daß die Einkernleiter und/oder die Mehrkernleiter mit hitzebeständigen Stoffen, wie z. B. Oxidkeramik, Glas- oder Quarzseide beschichtet bzw. ummantelt werden.

8. Verfahren nach einem oder mehreren der Ansprüche 1 bis 7, **dadurch gekennzeichnet,** daß der Sintermasse leicht zersetzliche Peroxide beigefügt werden, welche einen ständigen Überschuß an für die supraleitende Verbindung erforderlichen Sauerstoff gewährleisten.

9. Verfahren nach einem oder mehreren der Ansprüche 1 bis 8, **dadurch gekennzeichnet,** daß zur Erhöhung der kritischen Stromdichte den Pulvern für die Herstellung der supraleitenden Keramik feinkörnige Pulver aus normalleitenden Oxiden mit niedrigen freien Bildungsentalpien der Oxide beigemischt werden.

10. Verwendung der nach dem Verfahren gemäß den vorstehenden Ansprüchen hergestellten draht- und/oder bandförmigen Supraleiter zur Herstellung von Wicklungen für elektrische Geräte und Maschinen, insbesondere von Magnetwicklungen.

## Verfahren zur Herstellung von draht- und/oder bandförmigen Supraleitern aus keramischer Sinter-masse

Die Erfindung betrifft ein Verfahren zur Herstellung von draht- und/oder bandförmigen Supraleitern aus keramischer Sintermasse gemäß dem Oberbegriff des Patentanspruchs 1.

Aus keramischer Sintermasse bestehende Supraleiter haben den großen Vorteil, daß sie Sprungtemperaturen aufweisen, die über der Siedetemperatur des flüssigen Stickstoffs liegen. Hierzu verweisen wir auf folgende Literatur: "Zeitschrift für Physik", Bd. 64 (1986) S.189 und "Physical Review Letters", Vol. 58, Nr.18 (1987) S.1888, wo mehrere Supraleiter auf CuO-Basis mit Perovskite-Gitterstruktur und hohen Sprungtemperaturen beschrieben sind. Das supraleitende Material wird hierbei aus geeigneten oxidischen Pulvern, wie z. B. $Y_2O_3$, $BaCO_3$ und $CuO$ durch Mischen, Pressen, Sintern, ggf. mehrfaches Mahlen und thermische Zwischen- und Schlußbehandlung zur Erzielung der für die guten supraleitenden Eigenschaften verantwortlichen homogenen Gitterstruktur hergestellt, und zwar in Form von Sinterkörpern oder Schichten.

Die hohen Sprungtemperaturen und die hohen kritischen Magnetfeldstärken machen diese Stoffgruppen, wie z. B. $Ba_2YCu_3O_7$ für die Umformung zu technischen Supraleitern besonders interessant. Die in Form von Sinterkörpern oder Schichten vorliegenden supraleitenden Materialen können jedoch wegen ihrer Sprödigkeit nicht zu Drähten oder Bändern weiter verarbeitet werden, wie dies zur Her stellung von Wicklungen für elektrische Geräte und Maschinen, insbesondere aber von Magnetwicklungen nötig ist.

Der Erfindung liegt die Aufgabe zugrunde, ein Verfahren zu schaffen, mit dem die Herstellung von draht- und/oder bandförmigen Supraleitern aus keramischer sintermasse ermöglicht wird. Diese Aufgabe wird gemäß der Erfindung gelöst durch das im Patentanspruch 1 beschriebene Verfahren. Weitere Einzelheiten und Merkmale der Erfindung ergeben sich aus den Unteransprüchen. Es ist vorteilhaft, wenn in an sich bekannter Weise das Zermahlen, Pressen, Sintern und Wärmebehandeln des keramischen Materials vor dem Einfüllen in die Hüllkörper so oft wiederholt wird, bis die gewünschte Homogenität und Supraleitfähigkeit erreicht ist.

Zur Herstellung eines Mehrfachverbundes für filamentierte Leiter (Mehrkernleiter) können mehrere gefüllte und auf einen vorgegebenen Querschnitt reduzierte Hüllkörper als Bündel in einen weiteren Hüllkörper insbesondere aus Stabilisierungsmetall eingesetzt und erneut durch ein Kaltverformungsverfahren auf Enddimension gebracht werden. Als Hüllkörper eignen sich in besonderer Weise jene Metalle, die neben hohen Schmelztemperaturen hohe Duktilität und unbegrenzte Kaltverformbarkeit besitzen, so daß auf Zwischenwärmebehandlungen auf der Kaltverformungsstrecke verzichtet werden kann. Durch den Verzicht auf Zwischenwärmebehandlungen wird gleichzeitig erreicht, daß die nach kurzer Kaltverformung erreichte starke Verfestigung der Metallkörper eine für die weitere Verformung im Verbund mit den harten spröden Pulvern erforderliche Anpassung der mechanischen Härten bei der weiteren Verformung erhalten bleibt und nicht durch thermische Zwischenbehandlung unterbrochen wird. Für diesen Zweck haben sich Metalle, wie Tantal, Niob und Vanadium als besonders geeignet erwiesen, da sie auch gleichzeitig durch eine geringe Löslichkeit für Kupfer einen erweiterten Verbund mit Kupfer als Stabilisierungsmetall hoher elektrischer und thermischer Leitfähigkeit ermöglichen.

Gemäß weiterer Erfindung kann zur Erzeugung einer zusammenhängenden Sintermasse in den kaltverformten Hüllkörpern und zur Einstellung der optimalen supraleitenden Eigenschaften der Sintermasse nach der endgültigen Formgebung eine Schlußwärmebehandlung erfolgen.

Die Kaltverformung kann in an sich bekannter Weise durch Pressen, Ziehen oder Walzen erfolgen. Vorzugsweise werden die Einkernleiter und/oder die Mehrkernleiter mit hitzebeständigen Stoffen, wie z. B. Oxidkeramik, Glas- oder Quarzseide beschichtet bzw. ummantelt und in dieser Ummantelung einer Schlußwärmebehandlung ausgesetzt. Auf diese Weise können Wicklungen hergestellt werden, wie sie für elektrische Geräte und Maschinen, insbesondere aber für Magnetwicklungen erforderlich sind.

Weiterhin ist es zweckmäßig, leicht zersetzliche Peroxide der Sintermasse beizufügen, um einen ständigen Überschuß an Sauerstoff zu gewährleisten, der für die supraleitende Verbindung erforderlich ist.

Zur Erhöhung der kritischen Stromdichte können gemäß der Erfindung den Pulvern für die Herstellung der supraleitenden Keramik feinkörnige Pulver aus normalleitenden Oxiden mit niedrigen freien Bildungsentalpien der Oxide beigemischt werden.